Europäisches Patentamt

European Patent Office

Office européen des brevets

(19)

(11) Veröffentlichungsnummer: **0 268 065**
**A1**

# (12) EUROPÄISCHE PATENTANMELDUNG

(21) Anmeldenummer: **87114851.6**

(22) Anmeldetag: **12.10.87**

(51) Int. Cl.⁴: **H03M 9/00**

(30) Priorität: **29.10.86 CH 4281/86**

(43) Veröffentlichungstag der Anmeldung:
**25.05.88 Patentblatt 88/21**

(84) Benannte Vertragsstaaten:
**CH DE FR GB LI SE**

(71) Anmelder: **BBC Brown Boveri AG**

**CH-5401 Baden(CH)**

(72) Erfinder: **Maschek, Martin**
**Florastrasse 33**
**CH-8116 Würenlos(CH)**

(54) **Verfahren zur Seriell-Parallelumwandlung.**

(57) Die vorliegende Erfindung betrifft ein Verfahren zur Seriell-/Parallelumwandlung eines durch eine Zahlenfaktor und einen Messbereichsfaktor dargestellten Messwertes, bei welchem der Messbereichsfaktor oder dessen Logarithmus und der Zahlenfaktor jeweils unabhängig voneinander binär kodiert seriell vorliegen. Zur Umwandlung in ein dem Messwert entsprechendes einheitliches binäres Datenwort sind zwei Schieberegister ($SR_1$, $SR_2$) mit parallelen Ausgängen ($A_1$ -$A_3$, $A_4$ -$A_{22}$, $A_{23}$) vorgesehen. In eines der Schieberegister ($SR_1$) wird der Messbereichsfaktor oder dessen Logarithmus seriell eingelesen. Mit den parallelen Ausgängen ($A_1$ -$A_3$) dieses Schieberegisters ($SR_1$) ist eine Auswahlschaltung (AL) beaufschlagt. Das zweite Schieberegister ($SR_2$) ist mit mehreren seriellen Eingängen ($IN_6$ -$IN_{10}$) versehen. In dieses zweite Schieberegister ($SR_2$) wird der Zahlenfaktor seriell eingelesen und zwar über einen von der Auswahlschaltung (AL) ausgewählten Eingang. Die Auswahl wird von der Auswahlschaltung (AL) in Abhängigkeit von dem an den parallelen Ausgängen ($A_1$ -$A_3$) des ersten Schieberegisters ($SR_1$) erscheinenden parallelisierten binären Wert des Messbereichsfaktors oder dessen Logarithmus so getroffen, dass nach dem Einlesen des Zahlenfaktors in das zweite Schieberegister ($SR_2$) an dessen parallelen Ausgängen ($A_4$ -$A_{22}$, $A_{23}$) unmittelbar das dem Messwert entsprechende einheitliche binäre Datenwort erscheint.

EP 0 268 065 A1

## Verfahren zur Seriell-/Parallelumwandlung

### Technisches Gebiet

Die vorliegende Erfindung betrifft ein Verfahren zur Seriell-/Parallelumwandlung.

Sie betrifft insbesondere ein Verfahren zur Seriell-/Parallelumwandlung eines durch einen Messbereichsfaktor und einen Zahlenfaktor dargestellten Messwertes, bei welchem der Messbereichsfaktor oder dessen Logarithmus und der Zahlenfaktor jeweils unabhängig voneinander binär kodiert seriell vorliegen und mittels mindestens eines Schieberegisters mit parallelen Ausgängen in ein dem Messwert entsprechendes einheitliches binäres Datenwort umgewandelt werden.

### Stand der Technik

Bei digitaler Uebertragung von Messwerten hoher Dynamik ist es üblich, die Messwerte durch einen Zahlenfaktor und einen Messbereichsfaktor darzustellen und diese jeweils unabhängig voneinander binär kodiert zu übertragen. An Stelle des Messbereichsfaktors selbst könnte auch sein Logarithmus übertragen werden. Erfolgt die Uebertragung seriell, so müssen im empfangenden Teil die seriellen Daten parallelisiert, d.h. in ein paralleles Datenwort umgewandelt werden. Häufig möchte man diese Umwandlung so vornehmen, dass der Messwert nicht länger durch einen Zahlenfaktor und einen Messbereichsfaktor, sondern durch ein eineinheitliches Datenwort dargestellt ist.

Die Seriell-/Parallelumwandlung erfolgt üblicherweise mittels eines Schieberegisters mit parallelen Ausgängen. Die Bits des nacheinander seriell übertragenen Messwertfaktors (oder dessen Logarithmus) und des Zahlenfaktors werden in ein solches Schieberegister mit parallelen Ausgängen in einem ersten Schritt eingelesen. Erst in einem zweiten Schritt werden dann die an zwei Gruppen von Ausgängen des Schieberegisters erscheinenden binären, dem Zahlenfaktor und dem Messbereichsfaktor entsprechenden, parallelen Datenworte beispielsweise miteinander multipliziert, um ein einheitliches, dem Messwert entsprechendes binäres Datenwort zu erhalten.

Es ist auch bekannt, die Multiplikation durch Verschieben des Zahlenfaktors im Schieberegister vorzunehmen, wenn der Messbereichsfaktor nur ganzzahlige Potenzen von 2 annehmen kann (vgl. z.B. P.M.Kintner, Electronic Digital Technics, Mc Graw-Hill, 1968, Seite 177).

Nachteilig an dem bekannten Verfahren ist, dass die Parallelisierung in zwei Schritten erfolgt.

Dies erfordert Zeit. Bei hohen Uebertragungsraten könnte es erforderlich sein, mehrere Schieberegister mit entsprechender Logik zur Ausführung der Multiplikation vorzusehen, um die Datenraten zu bewältigen.

### Darstellung der Erfindung

Es ist Aufgabe der vorliegenden Erfindung, ein Verfahren der eingangs genannten Art anzugeben, welches schneller ist.

Die genannte, sowie weitere Aufgaben werden gemäss der vorliegenden Erfindung gelöst, durch die Angabe eines Verfahrens mit den Merkmalen des Anspruchs 1.

Die Vorteile des erfindungsgemässen Verfahrens sind insbesondere in einer kürzeren Verarbeitungszeit vom Beginn des Einlesens in die Schieberegister bis zur fertigen Ausgabe des einheitlichen binären Datenwortes zu sehen. Der Multiplikationsschritt entfällt.

Vorteilhafte Ausgestaltungen des erfindungsgemässen Verfahrens sind in den abhängigen Ansprüchen gekennzeichnet.

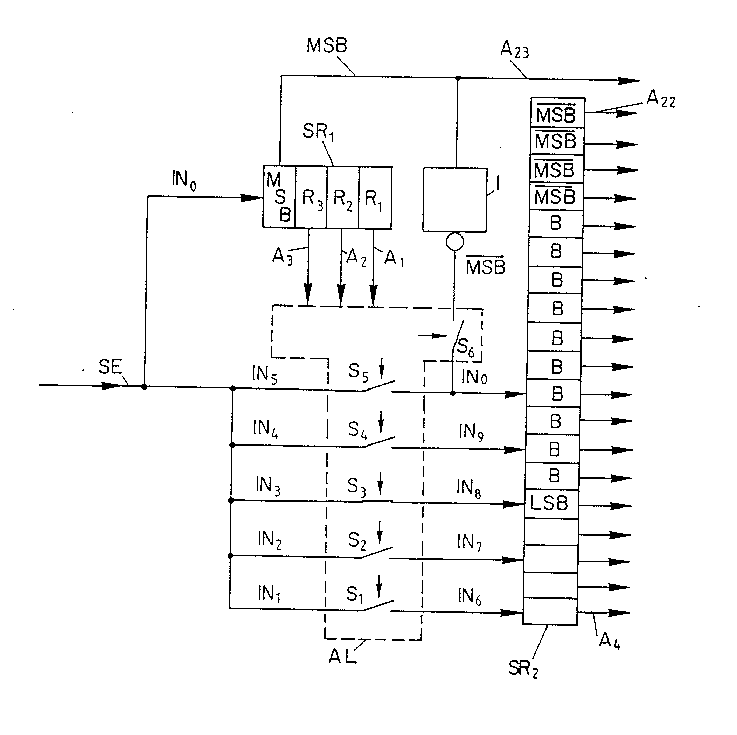

### Kurze Beschreibung der Zeichnung

Weitere Merkmale und Vorteile der vorliegenden Erfindung ergeben sich aus der nachstehenden ausführlichen Beschreibung, insbesondere unter Berücksichtigung der beigefügten Zeichnung. Diese zeigt in einer einzigen Figur in schematischer Darstellung eine Einrichtung zur Ausführung des erfindungsgemässen Verfahrens.

### Bester Weg zur Ausführung der Erfindung

Es wird nunmehr auf die Zeichnung Bezug genommen. In dieser ist mit SE ein serieller Eingangskanal bezeichnet. Dieser ist mit einem seriellen Eingang $IN_0$ eines ersten Schieberegisters $SR_1$ sowie mit fünf Eingängen $IN_1$ -$IN_5$ einer Auswahlschaltung AL verbunden. Die Auswahlschaltung AL wird steuermässig beaufschlagt von drei parallelen Ausgängen $A_1$ -$A_3$ des ersten Schieberegisters $SR_1$. Die Ausgänge $A_1$ -$A_3$ sind Ausgänge von drei benachbarten Registerzellen des ersten Schieberegisters $SR_1$. In der Auswahlschaltung sind sechs Schalter $S_1$ -$S_6$ vorgesehen. Ueber die Schalter $S_1$ -$S_5$ sind die Eingänge $IN_1$ -$IN_5$ auf serielle Eingänge $IN_6$ -$IN_{10}$ eines zweiten Schieberegisters $SR_2$ geschaltet. Das zweite Schieberegister $SR_2$ weist

mehr Registerstellen als das erste Schieberegister $SR_1$ auf. Durch den Eingang $IN_6$ wird die in der Zeichnung unterste oder niederwertigste Registerzelle des zweiten Schieberegister beaufschlagt. Eingang $IN_7$ beaufschlagt die dritte Registerzelle von unten, Eingang $IN_8$ die fünfte und so fort. Von den niederwertigen, untersten Registerzellen aus gesehen ist also bis zum Eingang $IN_{10}$ jede zweite Registerzelle mit einem Eingang beaufschlagt. Die Eingänge $IN_1$ -$IN_6$ sollen so zu verstehen sein, dass eine in sie eingespeiste Bitfolge jeweils nach oben zu den höherwertigen Registerzellen hin verschoben wird.

Das zweite Schieberegister $SR_2$ weist weiter zu jeder Registerzelle einen Ausgang auf. Die Ausgänge der Registerzellen bilden zusammen die parallelen Ausgänge $A_4$ -$A_{22}$ des zweiten Schieberegister $SR_2$.

Neben den drei bereits genannten Registerzellen des ersten Schieberegisters $SR_1$ weist dieses noch eine weitere, niederwertige Registerzelle als Eingangsregisterzelle auf. Auf diese ist der Eingang $IN_0$ geschaltet. Diese Registerzelle ist auch mit einem Ausgang versehen, welcher als Ausgang $A_{23}$ neben die parallelen Ausgänge $A_4$ -$A_{22}$ des zweiten Schieberegisters $SR_2$ tritt. Der Ausgang $A_{23}$ ist darüberhinaus über einen Inverter I und den Schalter $S_6$ in der Auswahlschaltung (AL) mit dem Eingang $IN_{10}$ des zweiten Schieberegisters $SR_2$ verbunden.

Es sei nun angenommen, dass über den seriellen Eingangskanal SE die in der Zeichnung dargestellte Einrichtung ein Datenblock erreicht. Dieser soll aus einer Folge von 15 Bits bestehen, die den Wert eines Messwertes in der Darstellung mit Zahlenfaktor und Messbereichsfaktor festlegen. Die ersten drei Bits sollen dem Messbereichsfaktor, die nachfolgenden Bits dem Zahlenfaktor des Messwertes zugeordnet sein. Die ersten drei Bits sollen hier insbesondere den Logarithmus des Messbereichsfaktors bedeuten, welcher nun die Werte 1,4, 16,64 und 256 annehmen kann. Sie werden nacheinander über den Eingang $IN_0$ in das erste Schieberegister $SR_1$ eingelesen und sind dort mit $R_1$, $R_2$ und $R_3$ bezeichnet. Zusätzlich wird in das erste Schieberegister $SR_1$ noch das erste, höchstwertige Bit MSB des nachfolgenden Zahlenfaktors eingelesen.

In Abhängigkeit von den an den Ausgängen $A_1$ -$A_3$ des ersten Schieberegisters $SR_1$ erscheinenden parallelisierten Werten des Logarithmus des Messbereichsfaktors entscheidet nun die Auswahlschaltung AL, welchen der Schalter $S_1$ -$S_5$ sie schliesst. Ueber den jeweils geschlossenen Schalter werden dann die restlichen Bits B des Zahlenfaktors bis hin zum letzten, niederwertigsten Bit LSB, in das Schieberegister $SR_2$ über den dem Schalter folgenden seriellen Eingang $IN_6$ -$IN_{10}$ eingelesen. Die Auswahl des jeweiligen Schalters $S_1$ -$S_5$ wird von der Auswahlschaltung AL so getroffen, dass an den parallelen Ausgängen $A_4$ -$A_{22}$ des zweiten Schieberegisters $SR_2$ (gegebenenfalls in Kombination mit dem Ausgang $A_{23}$) unmittelbar das dem Messwert entsprechende gewünschte einheitliche binäre Datenwort erscheint, dessen niederwertigstes Bit LSB die durch den Wert des Messbereichsfaktors angegebene Wertigkeit besitzt. Beträgt der Wert des Messbereichsfaktors gleich 1, so schliesst sie den Schalter $S_1$. Beträgt er gleich 4, so schliesst sie den Schalter $S_2$, beträgt er gleich 16, so schliesst sie den Schalter $S_3$ und so fort. Die Bits des Zahlenfaktors werden also gleich beim Einlesen in das zweite Schieberegister $SR_2$, das gleichzeitig Ausgangsregister der gesamten Vorrichtung ist, richtig plaziert. Eine Nachverarbeitung ist nicht erforderlich.

Die spezielle Behandlung des höchstwertigsten Bits MSB des Zahlenfaktors ist eine Spezialität des sogenannten "Offset Binary Codes". Beim sogenannten "Straight Binary Code" wäre dies nicht erforderlich; das höchstwertigste Bit MSB würde dort wie alle anderen Bits B bzw. LSB behandelt und mit in das zweite Schieberegister $SR_2$ mit eingelesen.

In allen Fällen, in denen die Bits des Zahlenfaktors B und LSB nicht über den obersten $IN_{10}$ der seriellen Eingänge $IN_6$ -$IN_{10}$ des zweiten Schieberegisters $SR_2$ in dieses eingelesen werden, bleiben 2 bis 8 der höchstwertigsten Registerzellen unbelegt. Diese werden bei Verwendung des "Offset Binary Code" beim Einlesen mit dem inversen Wert MSB des höchstwertigstenn Bits MSB des Zahlenfaktors geladen. Dazu sind der Inverter I und der Schalter $S_6$ vorgesehen. Letzterer wird wieder von der Auswahlschaltung AL entsprechend eingestellt.

Bei Verwendung des "Straight Binary Codes" könnten die nicht gebrauchten Registerzellen mit dem binären Wert "Null" beschrieben werden. Die unterhalb des niederwertigsten Bits LSB plazierten Registerzellen sind in ihrem Wert ohne Belang, da sie nur einen Bruchteil des niederwertigsten Bits LSB ausmachen.

Es sei noch angemerkt, dass, wenn der Messbereichsfaktor nicht nur, wie zuvor angenommen, die Werte 1,4,16,64 und 256 (gradzahlige Potenzen von 2) sondern auch noch die Werte 2,8,32 und 128 (ungradzahlige Potenzen von 2) annehmen könnte, nicht nur jede zweite Registerzelle (is zum Eingang $IN_{10}$), sondern jede Registerzelle des weiten Schieberegisters $SR_2$, mit einem seriellen Eingang versehen werden müsste. Entsprechend müsste die Auswahlschaltung Al erweitert werden.

## Ansprüche

1. Verfahren zur Seriell-/Parallelumwandlung eines durch einen Zahlenfaktor und einen Messbereichsfaktor dargestellten Messwertes, bei welchem der Messbereichsfaktor oder dessen Logarithmus und der Zahlenfaktor jeweils unabhängig voneinander binär kodiert seriell vorliegen und mittels mindestens eines Schieberegisters mit parallelen Ausgängen in ein dem Messwert entsprechendes einheitliches binäres Datenwort umgewandelt werden, dadurch gekennzeichnet, dass zwei Schieberegister ($SR_1$,$SR_2$) mit parallelen Ausgängen ($A_1$ -$A_3$, $A_4$ -$A_{22}$, $A_{23}$) vorgesehen sind, dass in eines der beiden Schieberegister ($SR_1$) der Messbereichsfaktor oder dessen Logarithmus seriell eingelesen wird, dass mit den parallelen Ausgängen ($A_1$ -$A_3$) dieses Schieberegisters ($SR_1$) eine Auswahlschaltung (AL) beaufschlagt ist, dass das zweite Schieberegister ($SR_2$) mehrere serielle Eingänge ($IN_6$ -$IN_{10}$) aufweist, dass in dieses zweite Schieberegister ($SR_2$) der Zahlenfaktor seriell eingelesen wird und dass von der Auswahlschaltung (AL) in Abhängigkeit von dem an den parallelen Ausgängen ($A_1$ -$A_3$) des ersten Schieberegisters ($SR_1$) erscheinenden parallelisierten binären Wert des Messbereichsfaktors oder dessen Logarithmus für das serielle Einlesen des Zahlenfaktors in das zweite Schieberegister ($SR_2$) einer der seriellen Eingänge ($IN_0$ -$IN_{10}$) dieses Schieberegisters ($SR_2$) derart angewählt wird, dass nach dem Einlesen an den parallelen Ausgängen ($A_4$ -$A_{22}$, $A_{23}$) dieses Schieberegisters ($SR_2$) unmittelbar das dem Messwert entsprechende einheitliche binäre Datenwort erscheint.

2. Verfahren nach Anspruch 1, dadurch gekennzeichnet, dass dem höchstwertigen ($IN_{10}$) der Eingänge ($IN_6$ -$IN_{10}$) des zweiten Schieberegisters ($SR_2$) beim Einlesen des Zahlenfaktors der invertierte Wert (MSB) des höchstwertigen Bits (MSB) des Zahlenfaktors zugeführt wird.

3. Verfahren nach Anspruch 1, dadurch gekennzeichnet, dass dem höchstwertigen ($IN_{10}$) der Eingänge ($IN_6$ -$IN_{10}$) des zweiten Schieberegisters ($SR_2$) beim Einlesen des Zahlenfaktors der binäre Wert "0" zugeführt wird.

4. Verfahren nach Anspruch 1, dadurch gekennzeichnet, dass die mehreren Eingänge ($IN_6$ -$IN_{10}$) des zweiten Schieberegisters ($SR_2$) Eingänge zu aufeinanderfolgenden Registerzellen oder zu aufeinanderfolgenden gleichgrossen Gruppen von Registerzellen des zweiten Schieberegisters ($SR_2$) sind.

5. Verfahren nach Anspruch 1, dadurch gekennzeichnet, dass die Auswahlschaltung (AL) eine Gruppe von mehreren Eingängen ($IN_6$ -$IN_{10}$) des zweiten Schieberegisters ($SR_2$) vorgeschalteten Schaltern ($S_1$ -$S_5$) beinhaltet.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-1 953 585 (V.E.B. STARKSTROM-ANLAGENBAU KARL-MARX-STADT) * Figur; Seite 4, Zeile 17 - Seite 7, Zeile 4 * <br>--- | 1 | H 03 M 9/00 |
| Y | IBM TECHNICAL DISCLOSURE BULLETIN, Band 17, Nr. 10, März 1975, Seite 2985, New York, US; J.R. MATHIS: "Serial-to-parallel converter" * Figur; Seite 2985 * <br>--- | 1 | |
| A | GB-A-2 162 977 (BRITISH TELECOMMUNICATIONS PLC) * Figur 1; Seite 1, Zeile 37 - Seite 2, Zeile 11 * <br>----- | 1 | |

RECHERCHIERTE
SACHGEBIETE (Int. Cl.4)

H 03 M
G 06 F

Der vorliegende Recherchenbericht wurde für alle Patentansprüche erstellt

| Recherchenort | Abschlußdatum der Recherche | Prüfer |
|---|---|---|
| DEN HAAG | 27-01-1988 | FEUER F.S. |